# EUROPEAN PATENT SPECIFICATION

(11) **EP 4 413 423 B1**
(45) Date of publication and mention of the grant of the patent: **08.04.2026**
(21) Application number: 22773735.0
(22) Date of filing: 13.09.2022
(51) Int. Cl.: G03F 7/20

(54) **CHAMBER FOR A PROJECTION SYSTEM OF A LITHOGRAPHIC APPARATUS, PROJECTION SYSTEM AND LITHOGRAPHIC APPARATUS**
KAMMER FÜR EIN PROJEKTIONSSYSTEM EINER LITHOGRAPHISCHEN VORRICHTUNG, PROJEKTIONSSYSTEM UND LITHOGRAPHISCHES GERÄT
CHAMBRE POUR UN SYSTÈME DE PROJECTION D'UN APPAREIL LITHOGRAPHIQUE, SYSTÈME DE PROJECTION ET APPAREIL LITHOGRAPHIQUE

(30) Priority: 06.10.2021 EP 21201183
(43) Date of publication of application: 14.08.2024
(73) Proprietor: ASML Netherlands B.V., 5500 AH Veldhoven (NL)
(72) Inventor: JANSSEN, Franciscus, Johannes, Joseph, 5500 AH Veldhoven (NL); ARLEMARK, Erik, Johan, 5500 AH Veldhoven (NL); GRZELKA, Jacek, 5500 AH Veldhoven (NL)
(74) Representative: ASML Netherlands B.V.
(86) International application number: PCT/EP2022/075331
(87) International publication number: WO 2023/057175

(56) References cited:
- US-A1- 2002 036 760
- US-A1- 2012 229 782
- US-A1- 2012 281 193
- US-A1- 2013 088 694
- US-A1- 2015 015 856

## Description

### FIELD

The present invention relates to a chamber for a projection system of a lithographic apparatus, a projection system for a lithographic apparatus and a lithographic apparatus.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Since EUV radiation is strongly absorbed by matter, within an lithographic apparatus using EUV radiation the optical path of the EUV radiation is under vacuum conditions (i.e. at pressures significantly below atmospheric pressure). In particular, the projection system, which comprises a system of optical elements for projecting the EUV radiation onto a substrate, may be held under vacuum conditions in a dedicated compartment of the lithographic apparatus. The EUV radiation is projected through an opening of said compartment onto the substrate. In order to avoid or mitigate the entering of contaminants into the projection system via said opening, a gas lock or gas seal is typically applied. Known gas locks or gas seals, as e.g. disclosed in US 2012/281193, US 2015/015856 or US 2012/229782, may however disturb the thermal condition of the substrate that is being patterned and/or the thermal condition of any sensors that are used in the vicinity of the opening. In addition, optical elements, e.g. optical elements in the projection system, may suffer from thermal disturbances caused by the gas lock as well. Such disturbances may adversely affect the accuracy of the patterning process.

### SUMMARY

It is an object of the present invention the provide and improved gas lock which can e.g. be used in an enclosure or chamber in a lithographic apparatus.

According to an aspect of the present invention, there is provided a chamber for a projection system of a lithographic apparatus, the chamber comprising:
- an opening configured to enable, during use, a patterned radiation beam to be projected onto a substrate that is arranged outside the chamber;
- a conduit having an outlet in the aperture, the conduit being configured to deliver a gas to the opening for providing a gas seal of the opening;
- a filter arranged in a flow path of the gas, at or near the outlet, the filter being configured to thermally condition the gas.

According to a further aspect of the present invention, there is provided a projection system for a lithographic apparatus, the projection system comprising a chamber according to the invention, and a plurality of optical elements arranged in the chamber and configured to, during use, project the patterned radiation beam onto the substrate.

According to a further aspect of the present invention, there is provided a lithographic apparatus comprising a projection system according to the invention.

According to yet a further aspect of the invention, there is provided a lithographic system comprising a lithographic apparatus according to the invention and a radiation source for generating a radiation beam.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus according to the invention and a radiation source;
- Figure 2 depicts a gas lock of a projection system as known in the art.
- Figure 3 depicts an embodiment of a gas lock or gas seal as can be applied in a chamber according to the invention.
- Figure 4 depicts a resulting heat load of a gas lock or gas seal according to the invention on a substrate, for different positions of a filter.

### DETAILED DESCRIPTION

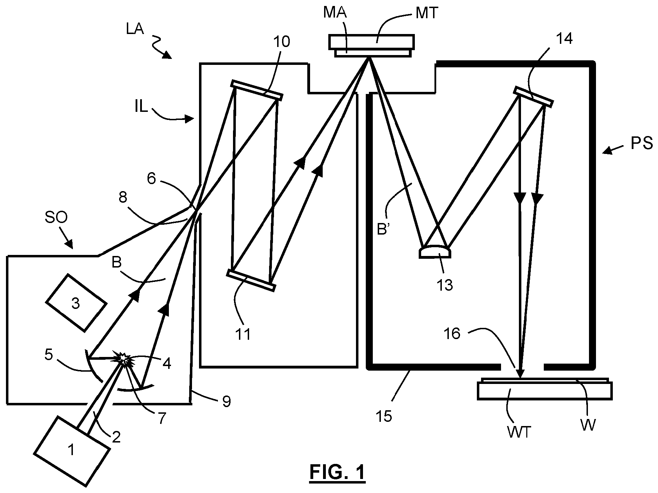

Figure 1 shows a lithographic system comprising a radiation source SO and a lithographic apparatus LA according to the invention. The radiation source SO is configured to generate an EUV radiation beam B and to supply the EUV radiation beam B to the lithographic apparatus LA. The lithographic apparatus LA according to the invention comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g., six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

Typically, the various sub-systems of the lithographic system may be arranged in different compartments or chambers. In particular, the projection system PS may be arranged in a chamber or enclosure 15 to avoid or mitigate contamination of the optical components such as mirrors 13, 14 shown in Figure 1. Said chamber or enclosure will typically have an opening or aperture 16 to allow the patterned radiation beam B' to be projected onto the substrate W. In order to avoid contamination entering the projection system PS via the opening, a gas lock or gas seal is provided in the opening 16. Said gas lock or gas seal comprises a conduit having an outlet in the opening 16 and being configured to deliver a gas to the opening. In accordance with the present invention, the gas lock or gas seal further comprises a filter that is arranged at or near the outlet, said filter being configured to thermally condition the gas. Further details on the gas lock and applied filter are provided below.

The radiation source SO shown in Figure 1 is, for example, of a type which may be referred to as a laser produced plasma (LPP) source. A laser system 1, which may, for example, include a CO₂ laser, is arranged to deposit energy via a laser beam 2 into a fuel, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a tin plasma 7 at the plasma formation region 4. Radiation, including EUV radiation, is emitted from the plasma 7 during deexcitation and recombination of electrons with ions of the plasma.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

Although Figure 1 depicts the radiation source SO as a laser produced plasma (LPP) source, any suitable source such as a discharge produced plasma (DPP) source or a free electron laser (FEL) may be used to generate EUV radiation.

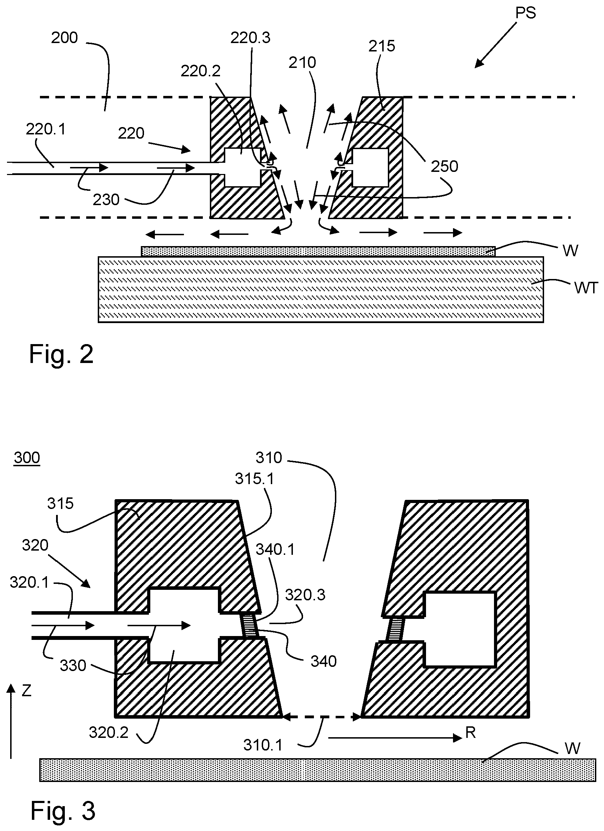

Figure 2 schematically shows a lower portion of a known projection system PS, in particular of a chamber or enclosure 200 of the projection system PS, the lower portion having an opening 210, defined by wall portion 215, via which a patterned radiation beam can be projected on a substrate W, the substrate W being held by a substrate table WT. In order to provide a gas lock or gas seal for the opening 210, a conduit 220 is provided to deliver a gas, indicate by the arrows 230, to an outlet of the conduit 220, thereby delivering the gas to the opening and creating a gas lock or gas seal. In the arrangement as shown, the conduit 220 comprises a pipe 220.1 supplying the gas to a chamber 220.2. Such a chamber 220.2 can e.g. be an annular chamber. The chamber 220.2 is connected to a slit 220.3 via which the gas is supplied to the opening 210. The slit 220.3 thus serving as an outlet of the gas. In Figure 2, the arrows 250 schematically indicate the gas flow from the opening 210 towards the substrate W and towards the interior of the projection system PS. It has been observed that the arrangement as shown in Figure 2 causes a positive heat load on the substrate due to stagnation and expansion gas effects. Within the meaning of the present invention, a positive heat load is a heat load or thermal load that causes a temperature rise in the object receiving the heat load, e.g. the substrate W. It has therefore been proposed to cool the gas as supplied to the opening 210 in order to reduce the heat load to the substrate W. Such cooling can e.g. include the use of heat pipes, heat exchangers, Peltier elements, etc. By doing so, the resulting heat load towards the substrate may indeed be reduced or brought near zero. It has however been devised by the inventors that, although the resulting heat load may be small or near zero, a heat flux may still occur on the object. In particular, it has been devised that the resulting near-zero heat load on an object, e.g. a substrate or a sensor arranged on the substrate table WT is in fact realized as a combination of areas of the object receiving a positive heat load and areas receiving a negative heat load. As a result, local cooling and heating effects may still occur, despite the near-zero resulting heat load. Within the meaning of the present invention, heat flux refers to a non-uniform heat load distribution on an object, e.g. a substrate or a sensor, said non-uniform heat load distribution causing a heat transfer, or heat flux, between areas having received different heat loads. Such a heat flux can be considered a transient or dynamic effect which can result in characteristics of a substrate or sensor changing over time. As an example, an expansion of a sensor arranged on the substrate table WT can be mentioned. Due to the heat flux as perceived by the sensor, the expansion of the sensor will be time-dependent. As a result, the measurement result as obtained from the sensor may be time-dependent as well. Phrased differently, the measurement result obtained from the sensor may depend on the instant at which the measurement is actually performed. Since this measurement result is e.g. relied upon for the patterning process, the patterning process may adversely be affected as well by the heat flux on the sensor. Similarly, a heat flux on the substrate will cause a time-dependent deformation of the substrate, which may also adversely affect to accuracy of the patterning process.

In accordance with the present invention, a different approach is therefore proposed to reduce the heat load on an object near a gas lock of a projection system of a lithographic apparatus. Rather than cooling the gas that is provided to the opening, it is proposed, in accordance with the present invention, to provide a filter in the flow path of the gas, the filter being provided at or near the gas outlet in the opening and being configured to thermally condition the gas. By guiding the gas flow through a filter that is arranged at or near the gas outlet in the opening, the gas flow that is leaving the filter can be considered to conduit as a regular normal distributed gas flow in a random direction.

In an embodiment, the filter can e.g. be made from a sintered material. In an embodiment, the filter is e.g. made from a metal such as stainless steel or from a ceramic material. Examples of such ceramic materials include but are not limited to Silicon Carbides such as SiC or SiSiC. In an embodiment, the filter can e.g. be made from a thermally conductive material.

Without being bound to any scientific theories, it is believe that for the given application of a gas lock or gas seal for a projection system or an enclosure of a projection system, the typical pore size of an applied filter will be much smaller than the mean free path length of the gas that is supplied. As a result, the last interactions when the gas is emitted by the filter will be interactions between the filter and the gas molecules rather than between gas molecules. As a result, the gas will obtain the thermal properties of the filter.

Figure 3 schematically shows a part of a chamber 300 for a projection system of a lithographic apparatus according to the invention. In Figure 3, reference number 315 refers to a wall portion of the chamber 300, the wall portion 315 defining an opening 310 of the wall, the opening 310 being configured to enable, during use, a patterned radiation beam to be projected onto a substrate W that is arranged outside the chamber 300. In the embodiment as shown, the wall portion 315 defining the opening 310 has a sloped inner surface 315.1. It can be pointed out that any other suitable shape may be applied as well. The inner surface 315.1 may e.g. be aligned with the indicated Z-direction or may even be curved. In an embodiment, the cross-section 310.1 of the opening 310 may e.g. have an annular or rectangular shape. Any shape suitable to allow, during use, the patterned radiation beam to pass and reach the substrate W may be applied. In the embodiment as shown, the chamber 300 further comprises a conduit 320 having an outlet 320.3 in the opening 310, the conduit 320 being configured to deliver a gas to the opening 310 for providing a gas seal of the opening 310. In the embodiment as shown, the conduit 320 comprises a pipe or pipe line 320.1 supplying the gas to a chamber 320.2 of the conduit. Such a chamber 320.2 can e.g. be an annular chamber surrounding the opening 310. In the embodiment as shown, the chamber 320.2 is connected to the opening 310 via the outlet 320.3 via which the gas is supplied to the opening 310. In an embodiment, the outlet 320.3 may e.g. be slit-shaped and may e.g. surround the entire opening 310 of the chamber 300. In accordance with the present invention, the chamber 300 further comprises a filter 340 that is arranged in a flow path of the gas, the flow path being indicated by the arrows 330, at or near the outlet 320.3, the filter 340 being configured to thermally condition the gas.

It has been devised by the inventors that by the addition of the filter 340, said filter being configured to thermally condition the gas, the adverse effects of the gas on the substrate W can be mitigated. It can also be mentioned that the application of the filter 340 according to the invention helps to avoid or mitigate a free gas expansion of the supply gas, which expansion would induce gas cooling and a heat transfer between the gas lock and the gas.

By including a filter 340 in the flow path of the supplied gas, in particular at or near the outlet 320.3 of the gas, it has been found that the thermal load presented by the gas can be controlled. In particular, the introduction of the filter 340 in the outlet 320.3 of the conduit 320 enables to control the thermal load, or heat load, on the substrate W or on a sensor that is applied at or near the opening 310 and which is affected by the gas flow. It has been confirmed by means of simulations and measurements that the application of the filter 340 enables to control the heat load, e.g. the heat load to the substrate or a sensor, to a predetermined value. In an embodiment, the heat load caused by the gas flow leaving the opening 310 towards the substrate can be tuned to zero or substantially zero. It has also been observed that the heat flux associated with the heat load can be tuned to zero or substantially zero as well, by the application of the filter. As a result, the aforementioned adverse effects of a heat flux occurring on a sensor or substrate can be mitigated by the invention.

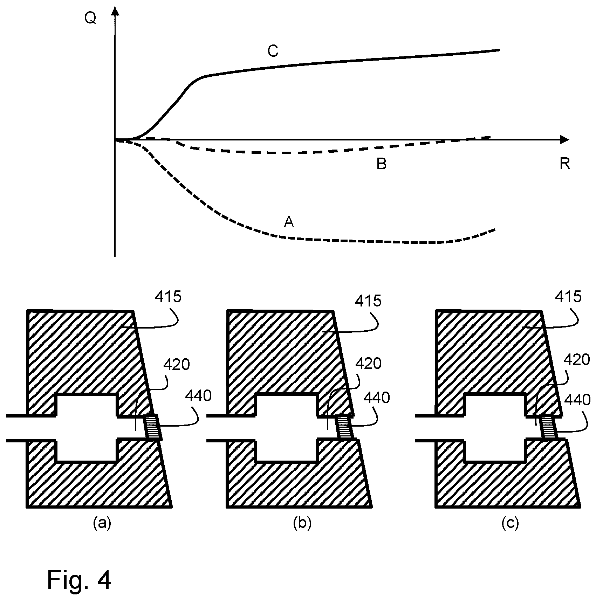

In an embodiment, the filter comprises a thermally conductive material, e.g. a porous material. By guiding the gas through a filter made from a thermally conductive material, the gas will substantially adhere to the temperature of the filter. Phrased differently, the gas will take the thermal properties of the filter and will be outputted by the filter in a random distributed direction. Once the gas has left the filter, a cooling effect will occur, due to an expansion of the gas and an alignment of the gas in the flow direction, i.e. either towards the substrate W or towards the interior of the chamber 300. As such, when the filter 340 is arranged such that its outer surface 340.1 which faces the opening 310 is arranged flush with the inner surface 315.1 of the opening or is arranged to protrude in the opening 310, a negative heat load will occur towards the substrate W. However, by changing the position of the filter 340 relative to the inner surface 315.1 of the opening 310, it has been found that the occurring heat load can be adjusted, i.e. tuned to a desired value. This is schematically illustrated in Figure 4.

The bottom part of Figure 4 schematically shows a portion 415 of a wall of a chamber according to the invention, the wall portion 415 defining an opening in the wall of the chamber. The wall portions 415 further comprise a filter 440 arranged in three different locations, relative to an outlet 420 of a gas supply into the opening. In arrangement (a), the filter 440 is arranged to slightly protrude from the outlet 420. In arrangement (b), the filter 440 is arranged slightly inward into the outlet 420. In arrangement (c), the filter 440 is arranged somewhat further inward into the outlet 420, compared to arrangement (b).

The top portion of Figure 4 schematically shows, for the three arrangements, the cumulative heat load Q [W] received by a substrate W as a function of the radial distance R from the center of the opening as indicated in Figure 3. Graph A in Figure 4 corresponds to the arrangement (a) shown in the bottom portion of Figure 4. As can be seen, the arrangement of the filter slightly outward of the wall portion 415 results in a negative heat load on the substrate. Graph B in Figure 4 corresponds to the arrangement (b) shown in the bottom portion of Figure 4. In such an arrangement, whereby the filter is arranged slightly inward of the wall portion 415, a near zero heat load on the substrate is obtained. Graph C in Figure 4 corresponds to the arrangement (c) shown in the bottom portion of Figure 4. As can be seen, the arrangement of the filter further inward, compared to arrangement (b), results in a positive heat load on the substrate.

Based on the above, it can be concluded that by means of a filter applied at or near an outlet of a gas supply in a gas lock or gas seal, a heat load, caused by the gas that is supplied, can be tuned. In particular, a strong dependency exists between the generated heat load and the position of the filter relative to the outlet of the gas supply.

Based on simulations, which were also confirmed by measurements, it has also been observed that the heat flux on a substrate or on a sensor that is used near the opening of the chamber, may also be reduced substantially.

Compared to the known arrangement, whereby a cooling arrangement is applied, it can be mentioned that the present invention provides in a passive arrangement which is far less complex than the known arrangement. It may however be pointed out that, in an embodiment of the present invention, the use of the filter at or near the outlet to the opening in the chamber or chamber wall can be combined with the use of a heater.

In such embodiment, the filter, e.g. filter 440 shown in Figure 4, may e.g. be arranged so as to generate a negative heat load on the substrate W. By heating the gas that is supplied to the opening of the chamber or chamber wall, one can however adjust the resulting heat load to the substrate, e.g. to a resulting heat load that is substantially zero. Regarding such an arrangement, whereby a heater is used to compensate for the negative heat load caused by the filter, it can be pointed out that the application of a heater can be considered to be less complex than the application of a cooler or cooling device.

In an embodiment of the present invention, the filter comprises a sintered metal sheet. A sintered material is made by compacting a powder of the material and forming a solid mass using heat or pressure without melting the material. Rather, the particles of the material, or the powder, are fused together. A sintered material can e.g. be characterized by its pore size or mean pore size.

In an embodiment of the present invention, a material is selected having a particular pore size which is related to the mean free path length of the applied gas.

As already mentioned above, the chamber according to the present invention may advantageously be in a vacuum environment. In such environment, the conduit of the chamber can e.g. be configured to receive the gas from a low pressure source, whereby a pressure of the low pressure source is e.g. in the range between 1-2 kPa and 1-2 Pa, e.g. in a range between 1 kPa and 2 Pa.. For a given pressure of a gas, the mean free path length of gas molecules can be determined. The following table illustrates this for a number of pressures:

| pressure | Mean free path |
|---|---|
| [Pa] | [m] |
| 1 | 1.1e-2 |
| 10 | 1.1e-3 |
| 100 | 1.1e-4 |
| 1000 | 1.1e-5 |

Based on the applied pressure in the conduit, a mean free path length of the gas may thus be determined. In an embodiment of the present invention, a material or structure is selected for the filter which has a pore size that is substantially smaller than the mean free path length. By doing so, one can ensure that the interactions of the gas molecules when traversing the filter, are primarily interactions with the filter material rather than interactions with other gas molecules. In an embodiment of the present invention, the filter is configured to have a pore size at least 5 times smaller, preferably 10 times smaller than a mean free path length of the supplied gas.

In order to ensure sufficient interactions between the gas and the filter, a suitable thickness of the filter can be selected, e.g. based on the mean free path length of the applied gas. In particular, in an embodiment of the present invention, the filter as applied has a thickness of at least 10 times, preferably at least 20 times the mean free path length of the supplied gas. In an embodiment, a thickness of the filter can e.g. be in a range from 0.1 to 10 mm, preferably in a range from 0.2 to 5 mm.

In an embodiment of the present invention, the outlet of the conduit, e.g. outlet 320.2 of conduit 320 shown in Figure 3, extends along the entire opening, e.g. opening 310 of Figure 3. In such embodiment, gas is thus supplied from an outlet that surrounds the entire opening. In such embodiment, the conduit can comprise one or more pipes such as pipe 320.1 which are configured to supply the gas to a chamber, e.g. chamber 320.2, which can distribute the gas to surround the opening, e.g. opening 310.

In an embodiment, the filter substantially covers the entire outlet of the conduit. In an embodiment, parts of the outlet of the conduit may be left open or may be covered with a different filter, e.g. a thinner filter or a filter with a different grade or pore size. By doing so, the resulting heat load to the substrate or sensor can be tuned as well. Such an embodiment may thus be applied as an alternative of or in addition to the inward positioning of the filter relative to the outlet.

In an embodiment of the present invention, the filter is arranged in the outlet. As is described above with reference to Figure 4, by arranging the filter in the outlet, the net heat load caused by the gas lock or gas seal on the substrate or sensor can be tuned. In particular, by arranging the filter somewhat inward in the outlet, e.g. outlet 320.3 of Figure 3 or the outlet 420 of Figure 4, the resulting heat load can be tuned to a desired value, e.g. to a net positive heat load, a net negative heat load or a near-zero heat load. It is worth mentioning that a correlation can be observed between the height of the filter and the inward position required to arrive at a particular resulting heat load; the larger the height of the filter, the further it should be moved inwards in the outlet, to arrive at a desired resulting heat load. Typical dimensions of the filter and position that can be mentioned are a filter height between 1 mm and 10 mm with an inward position between 0.1 mm and 5 mm.

The chamber according to the present invention as described above may advantageously be applied to accommodate optical elements, e.g. mirrors of a projection system of a lithographic apparatus.

As such, according to an aspect of the present invention, there is provided a projection system, e.g. projection system PS as shown in Figure 1, said projection system comprising a chamber according to the present invention a plurality of optical elements arranged in the chamber, said optical elements being configured to, during use, project a patterned radiation beam onto a substrate. In an embodiment, the optical elements as applied may e.g. be mirrors, e.g. mirrors configured to reflect an EUV radiation beam.

According to a further aspect of the present invention, there is provided a lithographic apparatus comprising a projection system according to the invention. Such a lithographic apparatus LA is schematically shown in Figure 1. In accordance with the present invention, the lithographic apparatus LA according to the invention may advantageously be combined with a radiation source for generating the radiation beam as used by the lithographic apparatus. As such, in an embodiment, the present invention provides a lithographic system comprising a lithographic apparatus according to the invention and a radiation source for generating a radiation beam.

As discussed above, the present invention enables to obtain an improved control over a heat load caused by a gas lock or gas seal of a chamber, e.g. a chamber of a projection system of a lithographic apparatus. Such improved control is obtained by the use of a filter in or near the outlet of the gas supply of the gas lock or gas seal. It is also worth mentioning that the application of the filter at least partially prevents particles, e.g. particles that are present in the supplied gas, to enter the chamber or contaminate the substrate or sensor near the opening of the chamber.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquidcrystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. Chamber (300) for a projection system (PS) of a lithographic apparatus (LA), the chamber (300) comprising:
- an opening (310) configured to enable, during use, a patterned radiation beam to be projected onto a substrate that is arranged outside the chamber (300);
- a conduit (320) having an outlet (320.3) in the opening (310), the conduit (320) being configured to deliver a gas to the opening (310) for providing a gas seal of the opening (310);
- a filter (340) arranged in a flow path of the gas, at or near the outlet, the filter (340) being configured to thermally condition the gas.

2. The chamber (300) according to claim 1, wherein the filter (340) comprises a porous metal material or a ceramic material.

3. The chamber (300) according to any of the preceding claims, wherein the filter (340) comprises a sintered metal sheet.

4. The chamber (300) according to any of the preceding claims, wherein the filter (340) is configured to thermally condition the gas to form a predetermined heat load for the substrate.

5. The chamber (300) according to claim 4, wherein the predetermined heat load is substantially zero.

6. The chamber (300) according any of the preceding claims, wherein the outlet (320.3) extends along the entire opening.

7. The chamber (300) according to claim 6, wherein the filter (340) substantially covers the entire outlet (320.3).

8. The chamber (300) according to claim 6 or 7, wherein the filter (340) is arranged in the outlet (320.3).

9. The chamber (300) according to claim 6, 7 or 8, wherein the filter (340) is arranged inward relative to a surface of the opening.

10. The chamber (300) according to any of the preceding claims, wherein the chamber (300) is configured to be applied in a vacuum environment, and wherein the conduit (320) is configured to receive the gas from a low pressure source, a pressure of the low pressure source being in the range of approx. 2 kPa to 1 Pa, preferably in a range of 1 kPa to 2 Pa.

11. The chamber (300) according to claim 10, wherein the filter (340) is configured to have a pore size at least 10 times smaller than a mean free path length of the supplied gas or wherein the filter (340) has a thickness of at least 10 times, preferably at least 20 times the mean free path length of the supplied gas.

12. The chamber (300) according to any of the preceding claims, wherein the filter (340) is configured to at least partially prevent particles to enter the chamber or contaminate the substrate.

13. Projection system (PS) for a lithographic apparatus, the projection system comprising
a chamber (300) according to any of the preceding claims, and
a plurality of optical elements arranged in the chamber (300) and configured to, during use, project the patterned radiation beam onto the substrate.

14. A lithographic apparatus comprising a projection system according to claim 13.

15. A lithographic system comprising a lithographic apparatus according to claim 14 and a radiation source for generating a radiation beam.

## Patentansprüche

1. Eine Kammer (300) für ein Projektionssystem (PS) einer lithographischen Vorrichtung (LA), wobei die Kammer (300) Folgendes beinhaltet:
- eine Öffnung (310), die konfiguriert ist, um während der Verwendung die Projektion eines strukturierten Strahlungsstrahls auf ein Substrat, das außerhalb der Kammer (300) angeordnet ist, ermöglichen;
- eine Leitung (320), die einen Auslass (320.3) in der Öffnung (310) aufweist, wobei die Leitung (320) konfiguriert ist, um zur Bereitstellung einer Gasdichtung der Öffnung (310) ein Gas an die Öffnung (310) zu liefern;
- einen Filter (340), der in einem Fließweg des Gases, an oder nahe dem Auslass, angeordnet ist, wobei der Filter (340) konfiguriert ist, um das Gas thermisch zu konditionieren.

2. Kammer (300) gemäß Anspruch 1, wobei der Filter (340) ein poröses Metallmaterial oder ein Keramikmaterial beinhaltet.

3. Kammer (300) gemäß einem der vorhergehenden Ansprüche, wobei der Filter (340) eine gesinterte Metallplatte beinhaltet.

4. Kammer (300) gemäß einem der vorhergehenden Ansprüche, wobei der Filter (340) konfiguriert ist, um das Gas thermisch zu konditionieren, um eine vorgegebene Wärmelast für das Substrat zu bilden.

5. Kammer (300) gemäß Anspruch 4, wobei die vorgegebene Wärmelast im Wesentlichen null ist.

6. Kammer (300) gemäß einem der vorhergehenden Ansprüche, wobei sich der Auslass (320.3) entlang der gesamten Öffnung erstreckt.

7. Kammer (300) gemäß Anspruch 6, wobei der Filter (340) im Wesentlichen den gesamten Auslass (320.3) abdeckt.

8. Kammer (300) gemäß Anspruch 6 oder 7, wobei der Filter (340) in dem Auslass (320.3) angeordnet ist.

9. Kammer (300) gemäß Anspruch 6, 7 oder 8, wobei der Filter (340) relativ zu einer Oberfläche der Öffnung einwärts angeordnet ist.

10. Kammer (300) gemäß einem der vorhergehenden Ansprüche, wobei die Kammer (300) konfiguriert ist, um in einer Vakuumumgebung angewandt zu werden, und wobei die Leitung (320) konfiguriert ist, um das Gas von einer Niederdruckquelle zu erhalten, wobei ein Druck der Niederdruckquelle in dem Bereich von ungefähr 2 kPa bis 1 Pa, vorzugsweise in einem Bereich von 1 kPa bis 2 Pa, liegt.

11. Kammer (300) gemäß Anspruch 10, wobei der Filter (340) so konfiguriert ist, dass er eine Porengröße aufweist, die mindestens 10-mal kleiner als eine mittlere freie Weglänge des zugeführten Gases ist oder wobei der Filter (340) eine Dicke von mindestens 10-mal, vorzugsweise mindestens 20-mal der mittleren freien Weglänge des zugeführten Gases aufweist.

12. Kammer (300) gemäß einem der vorhergehenden Ansprüche, wobei der Filter (340) konfiguriert ist, um mindestens teilweise zu verhindern, dass Partikel in die Kammer eintreten oder das Substrat kontaminieren.

13. Ein Projektionssystem (PS) für eine lithographische Vorrichtung, wobei das Projektionssystem Folgendes beinhaltet:
eine Kammer (300) gemäß einem der vorhergehenden Ansprüche und
eine Vielzahl von optischen Elementen, die in der Kammer (300) angeordnet sind und
konfiguriert sind, um während der Verwendung den strukturierten Strahlungsstrahl auf das Substrat zu projizieren.

14. Eine lithographische Vorrichtung, die ein Projektionssystem gemäß Anspruch 13 beinhaltet.

15. Ein lithographisches System, das eine lithographische Vorrichtung gemäß Anspruch 14 und eine Strahlungsquelle zum Erzeugen eines Strahlungsstrahls beinhaltet.

## Revendications

1. Chambre (300) pour un système de projection (PS) d'un appareil lithographique (LA), la chambre (300) comprenant :
- une ouverture (310) configurée pour permettre, durant l'utilisation, la projection d'un faisceau de rayonnement à motif sur un substrat qui est agencé à l'extérieur de la chambre (300) ;
- un conduit (320) ayant un orifice de sortie (320.3) dans l'ouverture (310), le conduit (320) étant configuré afin de délivrer un gaz à l'ouverture (310) pour fournir un joint à gaz de l'ouverture (310) ;
- un filtre (340) agencé dans une voie d'écoulement du gaz, au niveau ou près de l'orifice de sortie, le filtre (340) étant configuré pour conditionner thermiquement le gaz.

2. La chambre (300) selon la revendication 1, où le filtre (340) comprend un matériau en métal poreux ou un matériau en céramique.

3. La chambre (300) selon n'importe lesquelles des revendications précédentes, où le filtre (340) comprend une feuille métallique frittée.

4. La chambre (300) selon n'importe lesquelles des revendications précédentes, où le filtre (340) est configuré pour conditionner thermiquement le gaz afin de former une charge calorifique prédéterminée pour le substrat.

5. La chambre (300) selon la revendication 4, où la charge calorifique prédéterminée est substantiellement nulle.

6. La chambre (300) selon n'importe lesquelles des revendications précédentes, où l'orifice de sortie (320.3) s'étend sur toute la longueur de l'ouverture.

7. La chambre (300) selon la revendication 6, où le filtre (340) couvre substantiellement tout l'orifice de sortie (320.3).

8. La chambre (300) selon la revendication 6 ou la revendication 7, où le filtre (340) est agencé dans l'orifice de sortie (320.3).

9. La chambre (300) selon la revendication 6, la revendication 7 ou la revendication 8, où le filtre (340) est agencé vers l'intérieur relativement à une surface de l'ouverture.

10. La chambre (300) selon n'importe lesquelles des revendications précédentes, où la chambre (300) est configurée pour être mise en application dans un environnement sous vide, et où le conduit (320) est configuré pour recevoir le gaz en provenance d'une source basse pression, une pression de la source basse pression étant comprise dans l'intervalle d'approximativement 2 kPa à 1 Pa, préférablement dans un intervalle de 1 kPa à 2 Pa.

11. La chambre (300) selon la revendication 10, où le filtre (340) est configuré pour avoir un diamètre de pore au moins 10 fois plus petit qu'une longueur de libre parcours moyen du gaz amené ou bien où le filtre (340) a une épaisseur faisant au moins 10 fois, préférablement au moins 20 fois la longueur de libre parcours moyen du gaz amené.

12. La chambre (300) selon n'importe lesquelles des revendications précédentes, où le filtre (340) est configuré pour empêcher au moins partiellement que des particules ne pénètrent dans la chambre ou ne contaminent le substrat.

13. Système de projection (PS) pour un appareil lithographique, le système de projection comprenant
une chambre (300) selon n'importe lesquelles des revendications précédentes, et
une pluralité d'éléments optiques agencés dans la chambre (300) et configurés pour, durant l'utilisation, projeter le faisceau de rayonnement à motif sur le substrat.

14. Un appareil lithographique comprenant un système de projection selon la revendication 13.

15. Un système lithographique comprenant un appareil lithographique selon la revendication 14 et une source de rayonnement pour générer un faisceau de rayonnement.
